# EUROPÄISCHE PATENTANMELDUNG

(11) **EP 2 559 964 A1**
(43) Veröffentlichungstag der Anmeldung: **20.02.2013**
(21) Anmeldenummer: 12180018.9
(22) Anmeldetag: 10.08.2012
(51) Int. Cl.: F28F 3/12, H05K 7/20

(54) **Kühlvorrichtung für ein thermisch belastetes Bauteil**

(30) Priorität: 15.08.2011 DE 102011052707
(71) Anmelder: Pierburg GmbH, 41460 Neuss (DE)
(72) Erfinder: Sovva, Elina, 40223 Düsseldorf (DE); Kühnel, Hans-Ulrich, 41239 Mönchengladbach (DE)
(74) Vertreter: Patentanwälte ter Smitten Eberlein Rütten Partnerschaftsgesellschaft

(57) **Zusammenfassung**

Es sind Kühlvorrichtungen (22) für ein thermisch belastetes Bauteil (2) mit
einer Grundplatte (4), die ein Gehäuseteil des thermisch belasteten Bauteils (2) bildet, einem Gehäuse (24), in dem eine Ausnehmung (26) ausgebildet ist, deren offene Seite (28) gegen die Grundplatte (4) anliegt, wobei am Gehäuse (24) ein Kühlmitteleinlassstutzen (52) und ein Kühlmittelauslassstutzen (54) angeordnet sind, die über die Ausnehmung (26) fluidisch miteinander verbunden sind, bekannt.

Deren Befestigung ist insbesondere bei einem nachträglichen Einbau aufwendig.

Es wird daher vorgeschlagen, dass das Gehäuse (24) über eine zentrale Schraube (32) an der Grundplatte (4) befestigt ist, um welche sich zumindest teilweise die Ausnehmung (26) erstreckt.

## Beschreibung

Die Erfindung betrifft eine Kühlvorrichtung für ein thermisch belastetes Bauteil mit einer Grundplatte, die ein Gehäuseteil des thermisch belasteten Bauteils bildet, einem Gehäuse, in dem eine Ausnehmung ausgebildet ist, deren offene Seite gegen die Grundplatte anliegt, wobei am Gehäuse ein Kühlmitteleinlassstutzen und ein Kühlmittelauslassstutzen angeordnet sind, die über die Ausnehmung fluidisch miteinander verbunden sind.

Derartige Kühlvorrichtungen können sowohl zur aktiven Kühlung, beispielsweise einer Wärme erzeugenden Leistungselektronik, als auch zur thermischen Trennung eines Elektromotors oder eines Elektronikgehäuses von einem thermisch hoch belasteten Bauteil benutzt werden.

Insbesondere im Abgas führenden Bereich eines Verbrennungsmotors treten häufig hohe Temperaturen auf, welche insbesondere für Elektronikbauteile zu einer thermischen Überlastung führen können, die einen Ausfall des betreffenden elektronischen Bauteils bewirkt. Probleme sind vor allem dort zu erwarten, wo in einer ohnehin thermisch hoch belasteten Umgebung, wie dem Abgasstrang einer Verbrennungskraftmaschine ein Elektronikgehäuse angeordnet wird, in dem wiederum Wärme erzeugende Bauteile angeordnet sind. Eine derartige Konstellation führt dazu, dass thermische Isolierungen, wie sie beispielsweise für ein Elektronikgehäuse eines Elektromotors in Form von Doppelwandungen aus der DE 10 2008 022 369 A1 bekannt sind oder Hitzeschilder zwischen den Bauteilen nicht mehr ausreichen, um einen Ausfall der Elektronik zu vermeiden. Stattdessen muss bei derartigen Anordnungen aktiv gekühlt werden.

Eine solche aktive Kühlung zwischen einem Elektromotor und einem Abgasrückführventil ist beispielsweise aus der DE 103 44 218 A1 bekannt. Dieses Abgasrückführventil ist als Steckventil ausgebildet, wobei das den Abgaskanal bildende außenliegende Gehäuse, in welches das Steckventil gesteckt wird, eine zum Elektromotor des Abgasrückführventils offene ringförmige Nut aufweist, die über Kühlmitteleinlass- und -auslassstutzen mit Kühlmittel versorgt wird. Diese Nut wird durch eine Flanschplatte des Elektromotorgehäuses verschlossen. Hierdurch entsteht eine Kühlung des Elektromotors und des Ventils.

Die Ausbildung dieses Kühlkanals im Abgas führenden Gehäuse ist jedoch sehr kompliziert und muss entsprechend bei der Ausschreibung mit berücksichtigt und konstruiert werden, so dass eine eigene Konstruktion für jede Anwendung erforderlich ist.

Auch aus der DE 10 2005 042 784 A1 ist eine Kühlvorrichtung bekannt, welche aus einer Flanschplatte besteht, in der Kühlkanäle in Form von Bohrungen ausgebildet sind. Diese Platte wird anschließend mit dem zu kühlenden Bauteil verschraubt. Lediglich das auf diese Weise gekühlte Gehäuse hat entsprechend mit der dem Bauteil Kontakt, auf welches es geschraubt wird. Dies verringert den Kühlwirkungsgrad. Des Weiteren ist die Ausbildung mit den Kanälen und dem anschließenden Verschließen der überschüssigen Löcher aufwendig.

Es stellt sich daher die Aufgabe, eine Kühlvorrichtung für thermisch belastete Bauteile zu schaffen, welche nachträglich eingebaut und für verschiedene Einbauorte und Einsatzzwecke verwendet werden kann. Dabei soll die Montage möglichst einfach und kostengünstig durchzuführen sein.

Diese Aufgabe wird durch eine Kühlvorrichtung mit den Merkmalen des Hauptanspruchs 1 gelöst. Dadurch, dass das Gehäuse über eine zentrale Schraube an der Grundplatte befestigt ist, um welche sich zumindest teilweise die Ausnehmung erstreckt, ist die Montage mit extrem geringem Aufwand durchzuführen. Es wird auf einfache Weise ein durchströmbarer Kühlkanal auf der zu kühlenden Grundplatte ausgebildet. Die Kühlvorrichtung mit den Anschlussstutzen kann vollständig vormontiert werden und anschließend auf das ebenfalls fertig montierte zu kühlende Bauteil aufgesetzt und mit diesem verschraubt werden.

Vorzugsweise ist um die Ausnehmung in einer Nut ein erster Dichtring angeordnet. So wird auf einfache Weise sichergestellt, dass die als Kühlkanal dienende Ausnehmung nach außen abgedichtet ist, so dass kein Kühlmittel nach außen dringen kann.

Vorteilhafterweise ist radial innerhalb der Ausnehmung eine Nut ausgebildet, in der ein zweiter Dichtring angeordnet ist, wodurch auch eine Abdichtung nach innen zur Schraube sichergestellt wird.

Vorzugsweise ist das Gehäuse achssymmetrisch zu einer Achse durch die Schraube ausgebildet, so dass eine symmetrische Belastung der gegenüberliegenden Flächen erfolgt. Auf diese Weise ist eine Dichtigkeit über die Dichtringe deutlich leichter mit der einen Befestigungsschraube zu erreichen.

In einer besonders bevorzugten Ausführung ist eine Außenwand des Gehäuses rotationssymmetrisch ausgebildet, wodurch der nach außen abdichtende Dichtring mit einer gleichmäßigen Kraft gegen die Grundplatte gedrückt wird, was wiederum zu einer höheren Dichtigkeit der Verbindung führt.

Besonders vorteilhaft ist es, wenn die Ausnehmung im Wesentlichen ringförmig um die Schraube verläuft, da auf diese Weise der Strömungswiderstand im Kanal minimiert wird, so dass lediglich vernachlässigbar kleine Druckverluste vorliegen.

In einer weiterführenden Ausführung ist die Schraube in eine Gewindebuchse geschraubt, welche an der Grundplatte befestigt ist. So kann die Schraube auch an flachen Deckeln befestigt werden, welche keinen ausreichenden Platz zum Einschrauben bieten.

In diesem Fall weist das Gehäuse eine zentrisch angeordnete zylindrische Ausnehmung auf, in die die Gewindebuchse ragt. So kann durch zusätzliche Freiräume zwischen der Buchse und den Wänden des Kühlkanals Gewicht reduziert werden.

Dabei ist die radial innerhalb der Ausnehmung angeordnete Nut vorteilhafterweise an einer die Ausnehmung axial begrenzenden geschlossenen Wand des Gehäuses angeordnet und der zweite Dichtring liegt gegen die Gewindebuchse an. Entsprechend kann eine radial nach innen den Kühlkanal begrenzende Wand sehr dünn ausgeführt werden. Dennoch wird eine Dichtigkeit zur Schraube erreicht.

In einer bevorzugten Ausführung sind der Kühlmitteleinlassstutzen und der Kühlmittelauslassstutzen nebeneinander angeordnet, wobei zwischen dem Kühlmitteleinlassstutzen und dem Kühlmittelauslassstutzen eine den Querschnitt der Ausnehmung verschließende Trennwand ausgebildet ist. Entsprechend kann sich der Kanal weitestgehend vollständig um die Schraube erstrecken, wobei ein Überströmen zum Einlassstutzen durch die Trennwand verhindert wird. Dennoch wird eine große Kühlfläche zur Verfügung gestellt.

In einer alternativen Ausführung sind der Kühlmitteleinlassstutzen und der Kühlmittelauslassstutzen einander gegenüberliegend angeordnet. Da gleiche Druckverluste bei gleichen gegenüberliegenden Kanälen vorliegen, ist von einer gleichmäßigen Aufteilung der beiden Kühlmittelströme zu rechnen, so dass auch hier über die gesamte Fläche eine Kühlung sichergestellt wird. Je nach Erreichbarkeit der Anbindung zum Kühlmittelkreislauf können diese beiden Lösungen entsprechend gleichwertig eingesetzt werden.

Es wird somit eine Kühlvorrichtung für ein thermisch belastetes Bauteil geschaffen, die einfach zu montieren ist und nachträglich an eine beliebige Grundplatte montiert werden kann, so dass eine universelle Einsetzbarkeit gegeben ist. Dabei wird eine ausreichende Wärmeabfuhr sichergestellt.

Zwei Ausführungsbeispiele zweier erfindungsgemäßer Kühlvorrichtungen sind in den Figuren dargestellt und werden nachfolgend anhand einer Verwendung an einem Elektronikgehäuse beschrieben.
Figur 1 zeigt eine perspektivische Darstellung eines Elektronikgehäuses mit einer erfindungsgemäßen Kühlvorrichtung.
Figur 2 zeigt eine Seitenansicht des Elektronikgehäuses mit der Kühlvorrichtung gemäß Figur 1 in geschnittener Darstellung.
Figur 3 zeigt eine Ansicht von unten auf das Gehäuse der Kühlvorrichtung der Figur 1.
Figur 4 zeigt eine alternative Ausführung eines Gehäuses einer erfindungsgemäßen Kühlvorrichtung in Draufsicht.

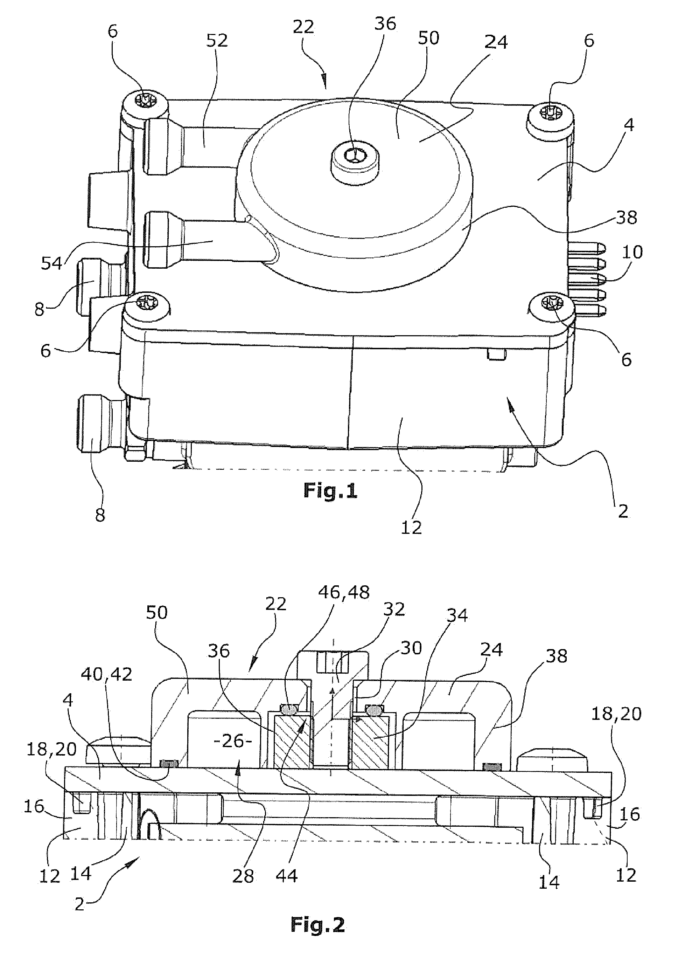

In Figur 1 ist ein quaderförmiges Elektronikgehäuse 2 zu erkennen, in dem eine nicht dargestellte Platine mit Leistungsbausteinen angeordnet ist und welches entsprechend ein thermisch belastetes Bauteil darstellt. Dieses Elektronikgehäuse 2 ist durch einen Deckel 4 mittels vier Schrauben 6 verschlossen. Aus dem Elektronikgehäuse 2 ragen zusätzlich verschiedene Stutzen 8 und Stecker 10 zum Anschluss der Elektronik. Seitenwände 12 des Elektronikgehäuses 2 sind doppelwandig ausgeführt, so dass zwischen der jeweils inneren Wand 14 und der äußeren Wand 16 ein Luftspalt ausgebildet ist, der isolierend wirkt. Eine Abdichtung des Elektronikgehäuses 2 zum äußeren Raum erfolgt durch eine Dichtung 18, welche in einer Nut 20 am zum Deckel 4 weisenden Ende der äußeren Wand 16 angeordnet ist.

Auf dem Deckel 4 ist eine erfindungsgemäße Kühlvorrichtung 22 angeordnet, deren Grundplatte direkt durch den Deckel 4 gebildet wird. Zusätzlich weist die Kühlvorrichtung 22 ein Gehäuse 24 auf, in welchem eine im Wesentlichen ringförmige Ausnehmung 26 ausgebildet ist, deren offene Seite 28 gegen den Deckel 4 anliegt und die sich um eine zentrale Bohrung 30 erstreckt, durch die eine zentrale Schraube 32 zur Befestigung des Gehäuses 24 an der Grundplatte 4 gesteckt ist. Diese Schraube 30 ist in eine Gewindebuchse 34 gedreht, welche auf dem Deckel 4 beispielsweise durch Schweißen befestigt ist. Entsprechend ragt die Gewindebuchse 34 in eine zentrische zylinderförmige Ausnehmung 36 des Gehäuses 24.

Die ringförmige Ausnehmung 26 wird entsprechend durch den Deckel 4 verschlossen. Um eine ausreichende Dichtigkeit sicher zu stellen, wenn die Ausnehmung 26 als Kühlmittel führender Kanal verwendet wird, ist in einer rotationssymmetrischen Außenwand 38 des Gehäuses eine umlaufende Nut 40 ausgebildet, in der ein erster Dichtring 42 angeordnet ist. Entsprechend kann kein Kühlmittel zwischen der Außenwand 38 und dem Deckel 4 hindurch nach außen dringen. Um auch eine Leckage entlang der Bohrung 30 zuverlässig zu verhindern, weist das Gehäuse 2 an seiner zur Gewindebuchse 34 weisenden Wandfläche 44 eine Nut 46 auf, in der ebenfalls ein zweiter Dichtring 48 angeordnet ist. Durch diese Anordnung kann eine Innenwand des Kühlmittelkanals beziehungsweise der Ausnehmung 26 sehr schmal gehalten werden.

Die Gehäuseaußenwand 38, wie auch eine die Ausnehmung 38 axial begrenzende obere Wand 50, in der die Bohrung 30 ausgebildet ist, sind rotationssymmetrisch ausgebildet, so dass trotz der Verwendung nur einer Schraube zur Befestigung eine gleichmäßig verteilte Klemmkraft auf die Dichtringe ausgeübt wird, was zu einer hohen Dichtigkeit trotz des einzelnen Befestigungspunktes führt.

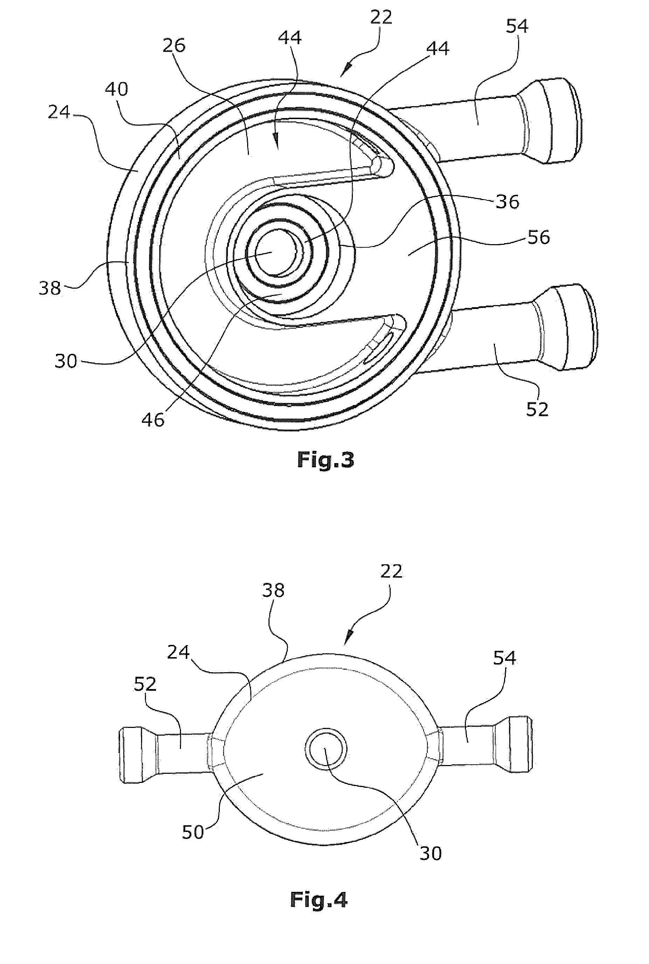

Am Gehäuse 24 ist zusätzlich ein Kühlmitteleinlassstutzen 52 und ein Kühlmittelauslassstutzen 54 ausgebildet, die die Außenwand 38 des Gehäuses 24 durchdringen und in der den Kühlmittelkanal bildenden Ausnehmung 26 münden. Bei der Ausführung gemäß der Figuren 1 bis 3 sind die beiden Kühlmittelstutzen 52, 54 parallel zueinander und nebeneinander angeordnet. Aus Figur 3 wird ersichtlich, dass sich die Ausnehmung 26 vom Kühlmitteleinlassstutzen 52 um die Ausnehmung 38 herum bis zum Kühlmittelauslassstutzen 54 im Wesentlichen ringförmig erstreckt, wobei eine Kurzschlussströmung vom Kühlmitteleinlassstutzen 52 zum Kühlmittelauslassstutzen 54 auf kurzem Weg durch eine Trennwand 56, die die Ausnehmung 26 unterbricht, verhindert wird. Entsprechend liegt keine vollständige ringförmige Umströmung vor. So existiert eine eindeutig definierte Strömung im Kühlmittelkanal.

Eine Alternative hierzu ist in Figur 4 dargestellt. Der Kühlmitteleinlassstutzen 52 liegt hier nicht mehr neben dem Kühlmittelauslassstutzen 54 sondern gegenüber. Die Ausnehmung ist bei dieser Ausführung vollständig ringförmig mit einem Kanal gleichbleibenden Querschnitts. Daher ist davon auszugehen, dass beide Kanalhälften vom Kühlmitteleinlassstutzen 52 um die Ausnehmung 38 herum zum Kühlmittelauslassstutzen 54 in gleicher Weise durchströmt werden.

Diese Kühlvorrichtungen lassen sich je nach Anschlussmöglichkeiten alternativ verwenden. Beide sind nachträglich mittels nur einer einzigen Schraube falls gewünscht auch nachträglich zu montieren. Der Kühlwirkungsgrad ist durch die unmittelbare Anbindung an den Deckel und somit die unmittelbare Umströmung des thermisch belasteten Gehäuses sehr hoch.

Es sollte deutlich sein, dass der Schutzbereich des Hauptanspruchs nicht auf das beschriebene Ausführungsbeispiel begrenzt ist. So kann beispielsweise alternativ die Schraube direkt in einem Gewinde im Deckel befestigt werden. Auch ist selbstverständlich eine andere Anwendung als die beschriebene geschützt. So kann die Kühlvorrichtung beispielsweise zur Kühlung von Elektromotoren, Elektroniken oder Ventilteilen vorgesehen werden.

## Patentansprüche

1. Kühlvorrichtung (22) für ein thermisch belastetes Bauteil (2) mit einer Grundplatte (4), die ein Gehäuseteil des thermisch belasteten Bauteils (2) bildet,
einem Gehäuse (24), in dem eine Ausnehmung (26) ausgebildet ist, deren offene Seite (28) gegen die Grundplatte (4) anliegt, wobei am Gehäuse (24) ein Kühlmitteleinlassstutzen (52) und ein Kühlmittelauslassstutzen (54) angeordnet sind, die über die Ausnehmung (26) fluidisch miteinander verbunden sind, **dadurch gekennzeichnet, dass**
das Gehäuse (24) über eine zentrale Schraube (32) an der Grundplatte (4) befestigt ist, um welche sich zumindest teilweise die Ausnehmung (26) erstreckt.

2. Kühlvorrichtung für ein thermisch belastetes Bauteil nach Anspruch 1,
**dadurch gekennzeichnet, dass**
um die Ausnehmung (26) in einer Nut (40) ein erster Dichtring (42) angeordnet ist.

3. Kühlvorrichtung für ein thermisch belastetes Bauteil nach einem der Ansprüche 1 oder 2,
**dadurch gekennzeichnet, dass**
radial innerhalb der Ausnehmung (26) eine Nut (46) ausgebildet ist, in der ein zweiter Dichtring (48) angeordnet ist.

4. Kühlvorrichtung für ein thermisch belastetes Bauteil nach einem der vorhergehenden Ansprüche,
**dadurch gekennzeichnet, dass**
das Gehäuse (24) achssymmetrisch zu einer Achse durch die Schraube (32) ausgebildet ist.

5. Kühlvorrichtung für ein thermisch belastetes Bauteil nach einem der vorhergehenden Ansprüche,
**dadurch gekennzeichnet, dass**
eine Außenwand (38) des Gehäuses (24) rotationssymmetrisch ausgebildet ist.

6. Kühlvorrichtung für ein thermisch belastetes Bauteil nach einem der vorhergehenden Ansprüche,
**dadurch gekennzeichnet, dass**
die Ausnehmung (26) im Wesentlichen ringförmig um die Schraube (32) verläuft.

7. Kühlvorrichtung für ein thermisch belastetes Bauteil nach einem der vorhergehenden Ansprüche,
**dadurch gekennzeichnet, dass**
die Schraube (32) in eine Gewindebuchse (34) geschraubt ist, welche an der Grundplatte (4) befestigt ist.

8. Kühlvorrichtung für ein thermisch belastetes Bauteil nach Anspruch 7,
**dadurch gekennzeichnet, dass**
das Gehäuse (24) eine zentrisch angeordnete zylindrische Ausnehmung (36) aufweist, in die die Gewindebuchse (34) ragt.

9. Kühlvorrichtung für ein thermisch belastetes Bauteil nach Anspruch 8,
**dadurch gekennzeichnet, dass**
die radial innerhalb der Ausnehmung (26) angeordnete Nut (46) an einer die Ausnehmung (26) axial begrenzenden geschlossenen Wand (50) des Gehäuses (24) angeordnet ist und der zweite Dichtring (48) gegen die Gewindebuchse (34) anliegt.

10. Kühlvorrichtung für ein thermisch belastetes Bauteil nach einem der vorhergehenden Ansprüche,
**dadurch gekennzeichnet, dass**
der Kühlmitteleinlassstutzen (52) und der Kühlmittelauslassstutzen (54) nebeneinander angeordnet sind, wobei zwischen dem Kühlmitteleinlassstutzen (52) und dem Kühlmittelauslassstutzen (54) eine den Querschnitt der Ausnehmung (26) verschließende Trennwand (56) ausgebildet ist.

11. Kühlvorrichtung für ein thermisch belastetes Bauteil nach einem der Ansprüche 1 bis 9,
**dadurch gekennzeichnet, dass**
der Kühlmitteleinlassstutzen (52) und der Kühlmittelauslassstutzen (54) einander gegenüberliegend angeordnet sind.
